# EUROPEAN PATENT APPLICATION

(11) **EP 4 773 508 A1**
(43) Date of publication of application: **08.07.2026**
(21) Application number: 25226804.0
(22) Date of filing: 23.12.2025
(51) Int. Cl.: H03K 5/05, H03K 5/156

(54) **CLOCK GENERATION CIRCUIT**

(30) Priority: 03.01.2025 US 202519009096
(71) Applicant: NXP B.V., 5656 AG Eindhoven (NL)
(72) Inventor: Yang, Youngmo, 5656AG Eindhoven (NL); Bae, Cheon Ho, 5656AG Eindhoven (NL)
(74) Representative: Krott, Michel

(57) **Abstract**

One example discloses a clock generation circuit, including: a clock base circuit configured to receive a clock request (req_pulse) signal having a pulse width; wherein the clock base circuit is configured to generate a clock output signal having a predetermined number of cycles based on the pulse width of the clock request (req_pulse) signal.

## Description

The present specification relates to systems, methods, apparatuses, devices, articles of manufacture and instructions for clock generation.

### SUMMARY

According to an example embodiment, a clock generation circuit, comprising: a clock base circuit configured to receive a clock request (req_pulse) signal having a pulse width; wherein the clock base circuit is configured to generate a clock output signal having a predetermined number of cycles based on the pulse width of the clock request (req_pulse) signal.

In another example embodiment, the clock base circuit includes a flip-flop configured to cycle the clock output signal; and the clock output signal is taken at a clock input port of the flip-flop.

In another example embodiment, further comprising a short req pulse rejection circuit configured to generate a request pulse merge (req_merge) signal.

In another example embodiment, the short req pulse rejection circuit is configured to hold the req_merge signal in a high logic state for a predetermined time after the pulse width of the clock request (req_pulse) signal ends.

In another example embodiment, the predetermined time is configured to enable a complete cycle of the clock output (clk_out) signal to be generated by the clock base circuit before the clock output (clk_out) signal is terminated.

In another example embodiment, the short req pulse rejection circuit includes an OR gate.

In another example embodiment, the clock request (req_pulse) signal received by the short request pulse rejection circuit goes straight through the OR gate to generate a rising edge of the req_merge signal.

In another example embodiment, the rising edge of the req_merge signal generates a rising edge of the clock output (clk_out) signal.

In another example embodiment, the short req pulse rejection circuit includes a first flip-flop and a second flip-flop.

In another example embodiment, both the first flip-flop and the second flip-flop are configured to receive the clock output (clk_out) signal at their clock input port (CK).

In another example embodiment, both the first flip-flop and the second flip-flop couple their Q output port to the OR gate.

In another example embodiment, the first flip-flop is configured to receive the clock request (req_pulse) signal at a D input port; and a D input port of the second flip-flop is coupled to a Q output port of the first flip-flop.

In another example embodiment, the short req pulse rejection circuit is configured to extend the req_merge signal to ensure that the req_merge signal goes to a logic low state after the clock output signal (clk_out) goes to a logic low state.

In another example embodiment, the short req pulse rejection circuit is configured to extend the req_merge signal even if the clock request (req_pulse) signal goes to a logic low state before the clock output signal (clk_out) goes to a logic low state.

In another example embodiment, the clock request (req_pulse) signal is a first clock request signal, the pulse width is a first pulse width, and the set of clock signal cycles is a first set of clock signal cycles; and the clock generation circuit is configured to receive a second clock request signal, having a second pulse width, and in response generate a second set of clock signal cycles.

In another example embodiment, the second set of clock signal cycles is greater than the first set of clock signal cycles because the second pulse width is wider than the first pulse width.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example of a clock generation circuit.
Figure 2 represents an example clock base circuit within the clock generation circuit.
Figure 3 represents an example short request pulse rejection circuit within the clock generation circuit.
Figure 4 represents an example timing diagram for the clock generation circuit.
Figure 5 represents an example comparison between the clock generation circuit and other (not shown) clock generation circuits.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Digital design techniques for circuits using synchronous clocks continue to be developed, even as chip size (e.g. large-scale IC) has been rapidly increased. However, many of these circuit designs are not able to include sufficiently fast synchronous clocks, and as a result their capabilities are limited and there is difficulty in ensuring proper operation of the circuit's functions, such as when event based trigger signals are received that quickly request such operations.

These are applications where asynchronous clocks would better serve such functionality and enable high-speed circuit operations. However, many such asynchronous circuit designs can be glitchy due to noise on their internal signal paths and/or generated by their asynchronous clocks. Such signal glitches are in part in response to asynchronous event based signal requests they receive.

Now discussed examples of an asynchronous clock generation circuit. These example clock generation circuits have a controllable duty cycle, duration, a stable period, and are glitch-free no matter how often asynchronous requests for clock signals are received.

The clock cycles generated by these example clock generation circuits maintain an output clock periodicity even if input noise is mixed with the clock request signal. Every clock cycle output has a full period (i.e. no short clock pulses). These example circuits are duty cycle aladjustable and only require a clock request signal to cause these circuits to generate a controllable number of output clock cycles. These example clock generation circuits are helpful especially for asynchronous circuit designs where external oscillators cannot be provided.

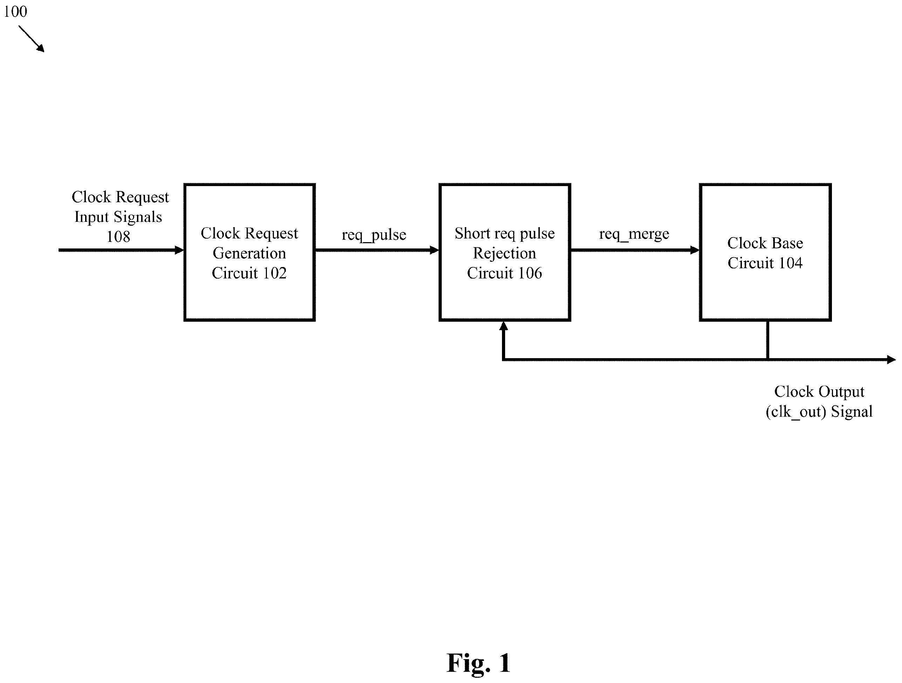

Figure 1 represents an example 100 of a clock generation circuit. The example clock generation circuit 100 includes a clock request generation circuit 102, a clock base circuit 104, and a short req pulse rejection circuit 106.

The clock request generation circuit 102 asynchronously receives various clock request input signals 108 from other circuits (not shown) that require clock signals to perform their functions. In response the clock request generation circuit 102 processes these various clock request input signals 108 to generate a request pulse (req_pulse) signal. The req_pulse signal have a specific pulse width. The specific pulse width instructs the clock base circuit 104 to generate a specific number of clock signal cycles before going quiescent.

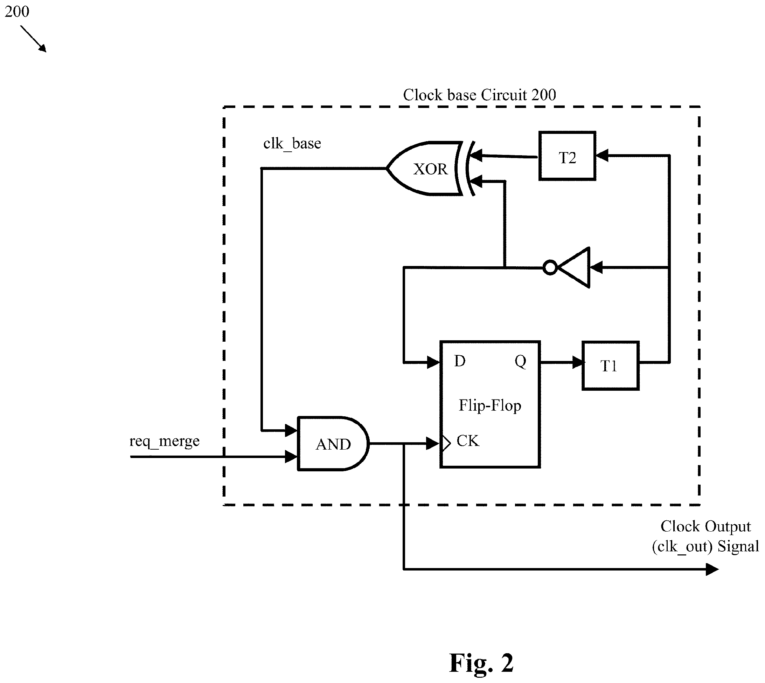

The clock base circuit 104 receives the req_pulse signal indirectly as a request pulse merge signal (req_merge) from the short req pulse rejection circuit 106. In response the clock base circuit 104 generates a clock output signal (clk_out) containing the specific number of clock signal cycles. Operation of the clock base circuit 104 in combination with the short req pulse rejection circuit 106 is discussed below in Figures 2-4.

Figure 2 represents an example clock base circuit 200 within the clock generation circuit 100. The clock base circuit 200 generates the clock output signal (clk_out) in response to the request pulse merge signal (req_merge).

The clock base circuit 200 includes an AND gate, a flip-flop (FF), a T1 delay, a T2 delay, and an XOR gate. The flip-flop (FF) has a clock input port (CK), a D input, and a Q output. The clock output signal (clk_out) taken at the clock input port (CK) of the flip-flop (FF).

Initially the FF is in a reset state where Q of the FF is 0 and thus a clock base signal (clk_base) is 1. Since initially the req_merge signal is 0, the AND gate output is also 0 and thus clk_out is 0.

If req_merge signal becomes 1, then the clock output signal (clk_out) is immediately generated by the AND gate output. The clock output signal (clk_out) cycles between logic 0 and logic 1. The high-duration (logic 1) is set by T1 and the low-duration (logic 0) is set by T2. Thus a duty cycle of the clock output signal (clk_out) can be adjusted by setting T1 and T2 to different values.

Then when the req_merge signal becomes 0, the clock output signal (clk_out) goes to 0 simultaneously.

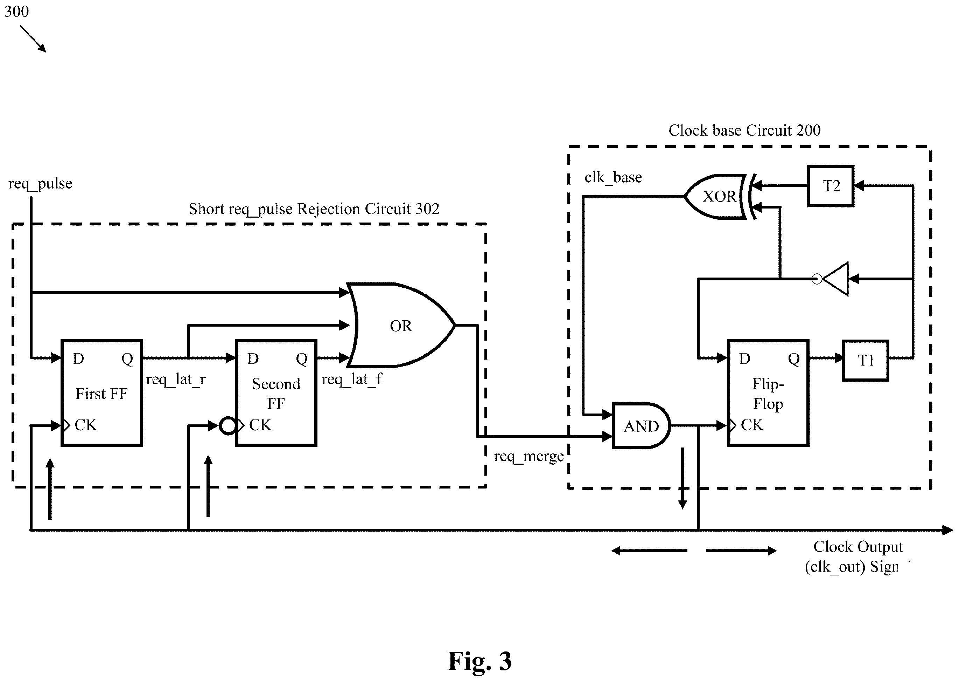

Since if the req_merge signal goes to 0 while the clock output signal (clk_out) is still 1, the high duration (logic 1) of the clock output signal (clk_out) signal may be smaller than T1, which may not be optimal for circuits (not shown) receiving the clock output signal (clk_out). The short req pulse rejection circuit 106 prevents this situation, as next discussed in Figure 3.

Figure 3 represents an example 300 short request pulse rejection circuit 302 within the clock generation circuit 100. The short pulse rejection circuit 302 is configured to prevent premature termination of the clock output signal (clk_out) during a last cycle before going quiescent.

To accomplish this, the short req pulse rejection circuit 302 is configured to hold the req_merge signal in a high logic state for a predetermined time after a pulse width of the clock req_pulse ends. The predetermined time is configured to enable a complete cycle of the clock output (clk_out) signal to be generated by the clock base circuit before terminating the clock output (clk_out) signal.

The short request pulse rejection circuit 302 includes a three-input OR gate, a first FF (flip-flop) having a clock input port (CK), a D input and a Q output, and a second FF (flip-flop) having a clock input port (CK), a D input and a Q output.

The req_pulse signal received by the short request pulse rejection circuit 302 goes straight through the OR gate to quickly generate a rising edge of the req_merge signal and then through the AND gate in the clock base circuit 200 to become the clock output signal (clk_out). This speed is enhanced since the CK input to the flip-flop is also used as clock output signal (clk_out).

Due to the OR gate, the pulse width of the req_pulse signal determines the number of cycles of the clock output signal (clk_out).

To prevent any clock output signal (clk_out) shortened cycles, the req_pulse signal should go to 0 after the clock output signal (clk_out) goes to 0. However, for situations where the req_pulse signal goes to 0 before the clock output signal (clk_out) goes to 0, the short pulse rejection circuit 302 extends the req_merge signal to ensure that the req_merge signal goes to 0 after the clock output signal (clk_out) goes to 0.

To accomplish this extension, first the req_pulse signal is registered by the rising edge of clk_out using the CK port of the first FF (flip-flop). The first FF (flip-flop) output is a req_lat_r signal. The req_lat_r signal is registered by falling edge of clk_out using the CK port of the second FF (flip-flop). The second FF (flip-flop) output is a req_lat _f signal.

Finally, the req_pulse signal, the req_lat_r signal, and the req_lat_f signal are merged using the OR gate to become part of the req_merge signal. The req_merge signal goes to the AND gate in the clock base circuit 200. The req_lat_r signal, and the req_lat _f signal extend the req_merge signal's high-duration (logic 1) to ensure that the req_merge signal does not go to a low state (logic 0) until after the clock output (clk_out) signal has completed a full high-duration (logic 1).

Thus complete cycles of the clock output (clk_out) signal are not cut-short/broken, even when the request pulse (req_pulse) signal is a very short pulse including glitch signals and/or other noise.

When there is no request pulse (req_pulse) signal, then there is no transition at the short req pulse rejection circuit 302 and thus clock output signal (clk_out) does not cycle either. This results in a lower power consumption of the clock generation circuit 100. Thus the clock generation circuit 100 is turned on/off by only the request pulse (req_pulse) signal.

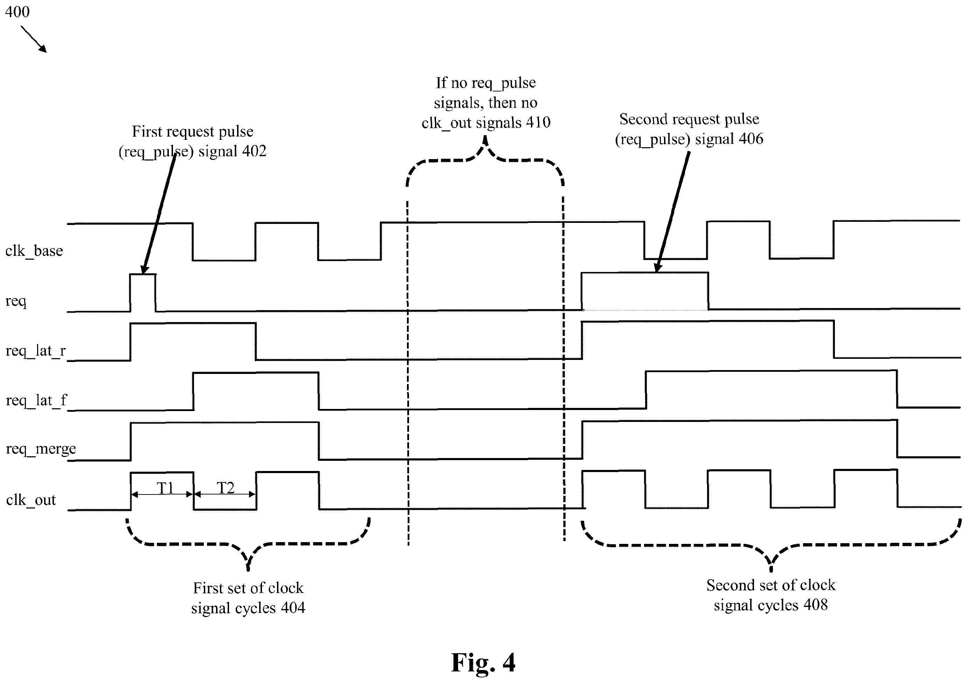

Figure 4 represents an example timing diagram 400 for the clock generation circuit 100.

The example timing diagram 400 shows a first request pulse (req_pulse) signal 402 has a first pulse width that generates a first set of clock signal cycles 404, and a second request pulse (req_pulse) signal 406 has a second pulse width that generates a second set of clock signal cycles 408.

Element 410 shows that when there are no request pulse (req_pulse) signals then there are no clock output (clk_out) signals.

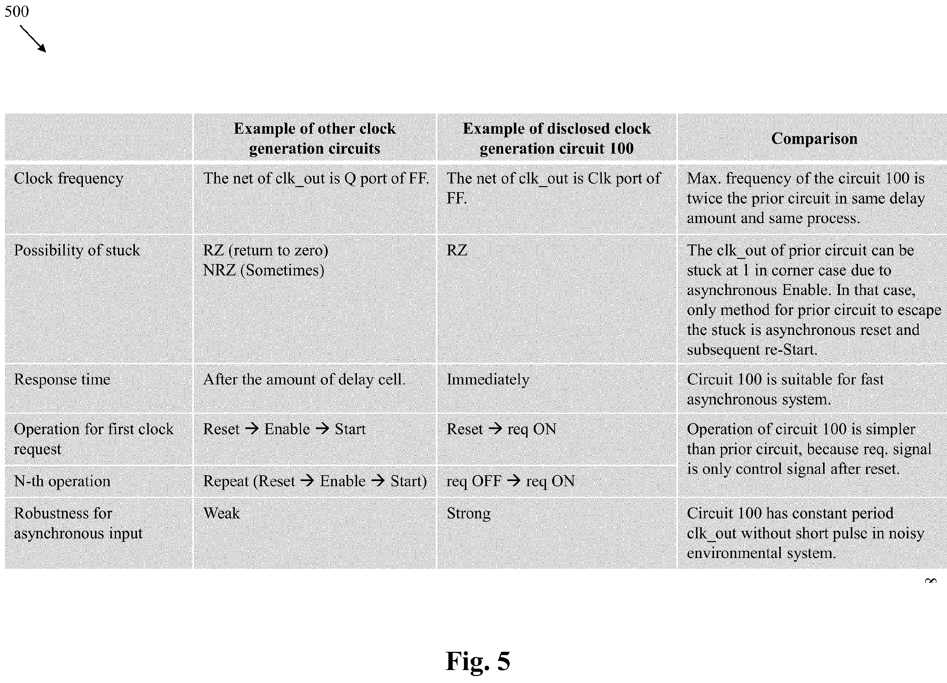

Figure 5 represents an example comparison 500 between the clock generation circuit 100 and other (not shown) clock generation circuits.

In many example embodiments the functionality described above is implemented using logic gates, application specific chips, firmware, and/or other hardware. However in some example embodiments this functionality can be implemented as a set of software instructions stored in a non-transitory computer-readable or computer-usable medium.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A clock generation circuit, comprising:
a clock base circuit configured to receive a clock request (req_pulse) signal having a pulse width;
wherein the clock base circuit is configured to generate a clock output signal having a predetermined number of cycles based on the pulse width of the clock request (req_pulse) signal.

2. The clock generation circuit of claim 1:
wherein the clock base circuit includes a flip-flop configured to cycle the clock output signal; and
wherein the clock output signal is taken at a clock input port of the flip-flop.

3. The clock generation circuit of claim 1 or 2:
further comprising a short req pulse rejection circuit configured to generate a request pulse merge (req_merge) signal.

4. The clock generation circuit of claim 3:
wherein the short req pulse rejection circuit is configured to hold the req_merge signal in a high logic state for a predetermined time after the pulse width of the clock request (req_pulse) signal ends.

5. The clock generation circuit of claim 4:
wherein the predetermined time is configured to enable a complete cycle of the clock output (clk_out) signal to be generated by the clock base circuit before the clock output (clk_out) signal is terminated.

6. The clock generation circuit of any one of claims 3 to 5:
wherein the short req pulse rejection circuit includes an OR gate.

7. The clock generation circuit of claim 6:
wherein the clock request (req_pulse) signal received by the short request pulse rejection circuit goes straight through the OR gate to generate a rising edge of the req_merge signal.

8. The clock generation circuit of claim 7:
wherein the rising edge of the req_merge signal generates a rising edge of the clock output (clk_out) signal.

9. The clock generation circuit of any one of claims 6 to 8:
wherein the short req pulse rejection circuit includes a first flip-flop and a second flip-flop.

10. The clock generation circuit of claim 9:
wherein both the first flip-flop and the second flip-flop are configured to receive the clock output (clk_out) signal at their clock input port (CK).

11. The clock generation circuit of claim 9 or 10:
wherein both the first flip-flop and the second flip-flop couple their Q output port to the OR gate.

12. The clock generation circuit of any one of claims 9 to 11:
wherein the first flip-flop is configured to receive the clock request (req_pulse) signal at a D input port; and
wherein a D input port of the second flip-flop is coupled to a Q output port of the first flip-flop.

13. The clock generation circuit of any one of claims 6 to 12:
wherein the short req pulse rejection circuit is configured to extend the req_merge signal to ensure that the req_merge signal goes to a logic low state after the clock output signal (clk_out) goes to a logic low state.

14. The clock generation circuit of claim 13:
wherein the short req pulse rejection circuit is configured to extend the req_merge signal even if the clock request (req_pulse) signal goes to a logic low state before the clock output signal (clk_out) goes to a logic low state.

15. The clock generation circuit of any preceding claim:
wherein the clock request (req_pulse) signal is a first clock request signal, the pulse width is a first pulse width, and the set of clock signal cycles is a first set of clock signal cycles; and
wherein the clock generation circuit is configured to receive a second clock request signal, having a second pulse width, and in response generate a second set of clock signal cycles.
